# EUROPEAN PATENT APPLICATION

(11) **EP 4 692 934 A1**
(43) Date of publication of application: **11.02.2026**
(21) Application number: 24780478.4
(22) Date of filing: 27.03.2024
(51) Int. Cl.: G03F 7/004, G03F 7/027, H05K 1/03

(54) **PHOTOSENSITIVE RESIN COMPOSITION, PHOTOSENSITIVE RESIN FILM, PRINTED WIRING BOARD, AND SEMICONDUCTOR PACKAGE**

(30) Priority: 29.03.2023 JP 2023052662
(71) Applicant: Resonac Corporation, Tokyo 105-7325 (JP)
(72) Inventor: KONNO, Yuko, Tokyo 105-7325 (JP); ABE, Kohei, Tokyo 105-7325 (JP); YUKIOKA, Ryo, Tokyo 105-7325 (JP); YAMADA, Kumpei, Tokyo 105-7325 (JP); NAKAMURA, Hidehiro, Tokyo 105-7325 (JP); KATAGI, Hideyuki, Tokyo 105-7325 (JP)
(74) Representative: Hoffmann Eitle
(86) International application number: PCT/JP2024/012289
(87) International publication number: WO 2024/204376

(57) **Abstract**

Disclosed are: a photosensitive resin composition containing (A) a photopolymerizable compound having an ethylenically unsaturated group and an acidic substituent and (B) a block isocyanate compound having a molecular weight of 3,000 or less; and a photosensitive resin film, a printed wiring board and a semiconductor package using the photosensitive resin composition.

## Description

### Technical Field

The present embodiment relates to a photosensitive resin composition, a photosensitive resin film, a printed wiring board, and a semiconductor package.

### Background Art

In recent years, miniaturization and high performance of electronic devices have been advanced, and printed wiring boards have been increased in density due to an increase in the number of circuit layers and miniaturization of wiring. In particular, a semiconductor package substrate such as ball grid array (BGA) or chip size package (CSP) on which a semiconductor chip is mounted has remarkably increased in density, and further reduction in the diameter of a thinning of an insulating layer and a via for interlayer connection is required in addition to miniaturization of wiring.

As a method for producing a printed wiring board which has been adopted in the related art, a method for producing a printed wiring board by a build-up method in which an interlayer insulating layer and a conductor circuit layer are sequentially laminated and formed (for example, refer to PTL 1) is exemplified. In a printed wiring board, a semi-additive process in which a circuit is formed by plating has been mainly used along with miniaturization of wiring.

In the conventional semi-additive process, for example, (1) a thermosetting resin film is laminated on a conductor circuit, and then the thermosetting resin film is cured by heating to form an "interlayer insulating layer". (2) Next, after a via for interlayer connection is formed by laser processing, desmear treatment and roughening treatment are performed by alkaline permanganate treatment. (3) After that, the substrate is subjected to electroless copper plating treatment, a pattern is formed using a resist, and then copper electroplating is performed to form a copper circuit layer. (4) Then, after the resist is peeled off, flash etching of the electroless plating layer is performed to form a copper circuit.

As described above, as a method of forming a via in an interlayer insulating layer formed by curing a thermosetting resin film, laser processing is mainly used, but the diameter reduction of a via by laser irradiation using a laser processing machine is reaching a limit. Furthermore, in the formation of a via by a laser processing machine, it is necessary to form each via hole one by one, and in a case where it is necessary to provide a large number of vias due to an increase in density, there is a problem in that a large amount of time is required for the formation of a via and production efficiency is poor.

Under such circumstances, as a method capable of collectively forming a large number of vias, a method has been proposed in which a plurality of small-diameter vias is collectively formed by a photolithography method using a photosensitive resin composition containing an acid-modified vinyl group-containing epoxy resin, a photopolymerizable compound, a photopolymerization initiator, an inorganic filler, and a silane compound, in which the content of the inorganic filler is 10 to 80% by mass (for example, refer to PTL 2).

### Citation List

### Patent Literature

PTL 1: JP 7-304931 A
PTL 2: JP 2017-116652 A

### Summary of Invention

### Technical Problem

Incidentally, with an increase in the speed and capacity of signals, a substrate material of a printed wiring board is required to have dielectric characteristics capable of reducing a transmission loss of a high-frequency signal (hereinafter, may be referred to as "high-frequency characteristics"), that is, a low relative dielectric constant and a low dielectric dissipation factor.

In the photosensitive resin composition, from the viewpoint of photosensitive properties, a photosensitive resin having an acidic substituent such as a carboxy group is sometimes used as the photosensitive resin. However, according to the studies of the present inventors, it has been found that it is difficult for a photosensitive resin composition containing such a photosensitive resin to achieve both dielectric characteristics and developability.

In view of such circumstances, an object of the present embodiment is to provide a photosensitive resin composition capable of achieving both dielectric characteristics and developability, and a photosensitive resin film, a printed wiring board, and a semiconductor package using the photosensitive resin composition.

### Solution to Problem

As a result of studies to solve the above problems, the present inventors have found that the above problems can be solved by the present embodiment described below.

That is, the present embodiment relates to the following [1] to [15].
[1] A photosensitive resin composition containing:
   (A) a photopolymerizable compound having an ethylenically unsaturated group and an acidic substituent; and
   (B) a block isocyanate compound having a molecular weight of 3,000 or less.
[2] The photosensitive resin composition according to [1], in which the component (B) has a dissociation temperature of 80 to 250°C.
[3] The photosensitive resin composition according to [1] or [2], in which the component (B) is a compound containing an isocyanurate ring.
[4] The photosensitive resin composition according to [3], in which the component (B) is a compound obtained by blocking a trifunctional isocyanate compound containing an isocyanurate ring with a blocking agent.
[5] The photosensitive resin composition according to [1] to [4], in which a content of the component (B) is 1 to 40% by mass based on the total amount of the resin components.
[6] The photosensitive resin composition according to any one of [1] to [5], in which the component (A) contains an alicyclic skeleton represented by the following general formula (A-1): 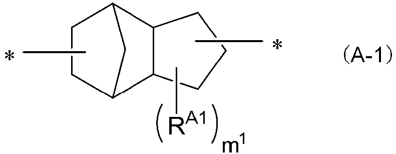 in which, R^{A1} represents an alkyl group having 1 to 12 carbon atoms, and may be substituted at any position in the alicyclic skeleton; m¹ is an integer of 0 to 6; and * is a bonding site to another structure.
[7] The photosensitive resin composition according to any one of [1] to [6], further containing (C) a thermosetting resin.
[8] The photosensitive resin composition according to any one of [1] to [7], further containing (D) a photopolymerization initiator.
[9] The photosensitive resin composition according to any one of [1] to [8], further containing (E) a crosslinking agent.
[10] The photosensitive resin composition according to any one of [1] to [9], further containing (F) an elastomer.
[11] The photosensitive resin composition according to any one of [1] to [10], further containing (G) an inorganic filler.
[12] The photosensitive resin composition according to any one of [1] to [11], which is used for forming a photovia.
[13] A photosensitive resin film containing the photosensitive resin composition according to any one of [1] to [12].
[14] A printed wiring board including a cured product of the photosensitive resin composition according to any one of [1] to [12].
[15] A semiconductor package including the printed wiring board according to [14], and a semiconductor element.

### Advantageous Effects of Invention

According to the present embodiment, it is possible to provide a photosensitive resin composition capable of achieving both dielectric characteristics and developability, and a photosensitive resin film, a printed wiring board, and a semiconductor package using the photosensitive resin composition.

### Brief Description of Drawings

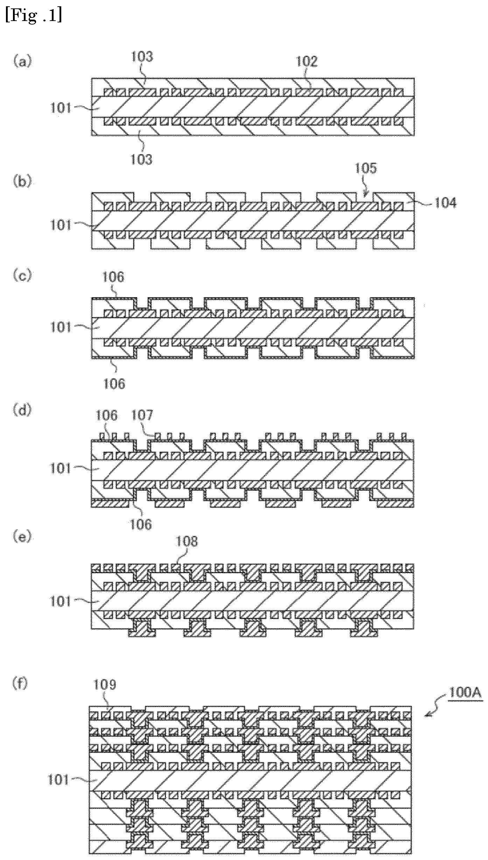

Figs. 1(a) to 1(f) are schematic views showing one embodiment of a process for producing a printed wiring board using the photosensitive resin film of the present embodiment as a material for an interlayer insulating layer.

### Description of Embodiments

In the numerical range described in the description herein, the lower limit value and the upper limit value of the numerical range may be replaced with a value shown in Examples. In addition, the lower limit value and the upper limit value of the numerical range are arbitrarily combined with the lower limit value or the upper limit value of another numerical range, respectively. In the notation of the numerical range "AA to BB", the numerical values AA and BB at both ends are included in the numerical range as the lower limit value and the upper limit value, respectively.

In the description herein, for example, the description of "10 or more" means 10 and a numerical value exceeding 10, and the same applies to a case where the numerical value is different. Further, for example, the description of "10 or less" means 10 and a numerical value less than 10, and the same applies to a case where the numerical value is different.

In the description herein, when there are a plurality of kinds of substances corresponding to each component, the content of each component means the total content of the plurality of kinds of substances, unless otherwise specified.

In the description herein, the "solid content" means a nonvolatile content excluding a volatile substance such as a solvent. That is, the "solid content" means a component remaining without being volatilized when the resin composition is dried, and also includes a component in a liquid state at room temperature. In the description herein, room temperature means 25°C.

In the description herein, the "number of ring carbon atoms" refers to the number of carbon atoms necessary for forming a ring, and does not include the number of carbon atoms of a substituent which the ring has. For example, both the cyclohexane skeleton and the methylcyclohexane skeleton have 6 ring carbon atoms.

The notation "(meth)acryl XX" means one or both of acryl XX and the corresponding methacryl XX. In addition, the "(meth)acryloyl group" means one or both of an acryloyl group and a methacryloyl group.

In the description herein, for example, when a "layer" is described as in an interlayer insulating layer, the "layer" includes not only an aspect of a solid layer but also an aspect in which a part of the layer has an island shape, an aspect in which a hole is opened, and an aspect in which an interface with an adjacent layer is unclear.

The weight-average molecular weight (Mw) and the number-average molecular weight (Mn) in the description herein mean values measured by gel permeation chromatography (GPC) in terms of polystyrene. To be specific, the weight-average molecular weight (Mw) in the description herein can be measured by a method described in Examples.

The action mechanism described in the description herein is a conjecture, and does not limit the mechanism by which the effect of the present embodiment is exhibited.

An aspect in which matters described in the description herein are arbitrarily combined is also included in the present embodiment.

### [Photosensitive Resin Composition]

The photosensitive resin composition of the present embodiment is a photosensitive resin composition containing (A) a photopolymerizable compound having an ethylenically unsaturated group and an acidic substituent, and (B) a block isocyanate compound having a molecular weight of 3,000 or less.

The photosensitive resin composition of the present embodiment is suitable for forming a via by a photolithography method (also referred to as photovia formation), and therefore is suitable for forming one or more selected from the group consisting of a photovia and an interlayer insulating layer. That is, the photosensitive resin composition of the present embodiment is suitable for forming a photovia.

In addition, the photosensitive resin composition of the present embodiment is suitable for a negative photosensitive resin composition.

### <(A) Photopolymerizable Compound Having Ethylenically Unsaturated Group and Acidic Substituent>

The component (A) is a photopolymerizable compound having an ethylenically unsaturated group and an acidic substituent.

The component (A) may be used alone or may be used in combination of two or more types.

Since the component (A) has an ethylenically unsaturated group, it is a compound which exhibits photopolymerization property, particularly radical polymerizability.

Examples of the ethylenically unsaturated group contained in the component (A) include functional groups exhibiting photopolymerization property, such as a vinyl group, an allyl group, a propargyl group, a butenyl group, an ethynyl group, a phenylethynyl group, a maleimide group, a nadimide group, and a (meth)acryloyl group. Among these, a (meth)acryloyl group is preferable from the viewpoint of reactivity and resolution of a via.

The component (A) has an acidic substituent from the viewpoint of enabling alkali development.

Examples of the acidic substituent of the component (A) include a carboxy group, a sulfonic acid group, and a phenolic hydroxy group. Among these, a carboxy group is preferable from the viewpoint of the resolution of a via.

The acid value of the component (A) is preferably 20 to 200 mgKOH/g, more preferably 40 to 180 mgKOH/g, still more preferably 70 to 150 mgKOH/g, and particularly preferably 90 to 120 mgKOH/g. When the acid value of the component (A) is equal to or greater than the above lower limit value, the solubility of the photosensitive resin film in a dilute alkaline solution tends to be excellent, and when it is equal to or less than the above upper limit value, the dielectric characteristics tend to be excellent. The acid value of the component (A) can be measured by the method described in Examples.

In addition, two or more kinds of components (A) having different acid values may be used in combination, and in this case, it is preferable that the weighted average acid value of the acid values of the two or more kinds of components (A) is within any range described above.

The weight-average molecular weight (Mw) of the component (A) is preferably 600 to 30,000, more preferably 800 to 25,000, still more preferably 1,000 to 18,000, even more preferably 1,100 to 8,000, particularly preferably 1,200 to 5,000, and most preferably 1,200 to 3,500. When the weight-average molecular weight (Mw) of the component (A) is within the above range, the adhesive strength with copper plating, heat resistance, and insulating reliability tend to be excellent.

The component (A) preferably contains an alicyclic skeleton from the viewpoint of dielectric characteristics.

The alicyclic skeleton of the component (A) is preferably an alicyclic skeleton having 5 to 20 ring carbon atoms, more preferably an alicyclic skeleton having 5 to 18 ring carbon atoms, still more preferably an alicyclic skeleton having 6 to 18 ring carbon atoms, particularly preferably an alicyclic skeleton having 8 to 14 ring carbon atoms, and most preferably an alicyclic skeleton having 8 to 12 ring carbon atoms, from the viewpoint of the resolution of a via, the adhesive strength with copper plating, and the electrical insulating reliability.

In addition, the alicyclic skeleton is preferably composed of two or more rings, more preferably composed of two to four rings, and still more preferably composed of three rings, from the viewpoint of the resolution of a via, the adhesive strength with copper plating, and the electrical insulating reliability. Examples of the alicyclic skeleton having two or more rings include a norbornane skeleton, a decalin skeleton, a bicycloundecane skeleton, and a saturated dicyclopentadiene skeleton. In the description herein, the saturated dicyclopentadiene skeleton means a skeleton including a ring structure in which an unsaturated bond included in a dicyclopentadiene ring is saturated. Among these, a saturated dicyclopentadiene skeleton is preferable from the viewpoint of the resolution of a via, the adhesive strength with copper plating, and the electrical insulating reliability.

From the same viewpoint, the component (A) preferably contains an alicyclic skeleton represented by the following general formula (A-1).

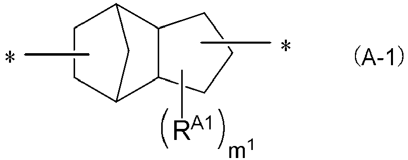

In the formula, R^{A1} represents an alkyl group having 1 to 12 carbon atoms, and may be substituted at any position in the alicyclic skeleton; m¹ is an integer of 0 to 6; and * is a bonding site to another structure.

In the general formula (A-1), examples of the alkyl group having 1 to 12 carbon atoms represented by R^{A1} include a methyl group, an ethyl group, a n-propyl group, an isopropyl group, a n-butyl group, an isobutyl group, a t-butyl group, and a n-pentyl group. The alkyl group is preferably an alkyl group having 1 to 6 carbon atoms, more preferably an alkyl group having 1 to 3 carbon atoms, and still more preferably a methyl group.

m¹ is an integer of 0 to 6, preferably an integer of 0 to 2, and more preferably 0.

When m¹ is an integer of 2 to 6, a plurality of R^{A1}'s may be the same or different from each other. Furthermore, a plurality of R^{A1}'s may be substituted on the same carbon atom to the extent possible, or may be substituted on different carbon atoms.

* is a bonding site to another structure, and may be bonded at any carbon atom on the alicyclic skeleton, but is preferably bonded at a carbon atom of a site represented by 1 or 2 and a carbon atom of a site represented by 3 or 4 in the following general formula (A-1').

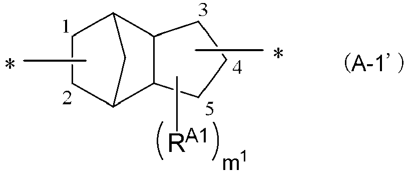

In the formula, R^{A1}, m¹ and * are the same as those in the general formula (A-1).

The component (A) is preferably an acid-modified vinyl group-containing epoxy resin obtained by reacting (a3) a saturated group- or unsaturated group-containing polybasic anhydride with a compound obtained by modifying (a1) an epoxy resin with (a2) an ethylenically unsaturated group-containing organic acid [hereinafter the compound may be referred to as a component (A')], from the viewpoint of the resolution of a via and the adhesive strength with copper plating. Here, the "acid-modified" of the acid-modified vinyl group-containing epoxy resin means having an acidic substituent, the "vinyl group" means an ethylenically unsaturated group, the "epoxy resin" means using an epoxy resin as a raw material, and the acid-modified vinyl group-containing epoxy resin is not necessarily required to have an epoxy group, and may not have an epoxy group.

Hereinafter, preferred embodiments of the component (A) obtained from (a1) an epoxy resin, (a2) an ethylenically unsaturated group-containing organic acid, and (a3) a saturated group- or unsaturated group-containing polybasic acid anhydride will be described.

### ((a1) Epoxy Resin)

The epoxy resin (a1) is preferably an epoxy resin having two or more epoxy groups.

The epoxy resin (a1) may be used alone or may be used in combination of two or more types.

The epoxy resin (a1) is classified into a glycidyl ether type epoxy resin, a glycidyl amine type epoxy resin, and a glycidyl ester type epoxy resin. Among these, a glycidyl ether type epoxy resin is preferable.

The epoxy resin (a1) can be classified into various epoxy resins depending on the difference in the main skeleton, and can be classified into an epoxy resin having an alicyclic skeleton, a novolac type epoxy resin, a bisphenol type epoxy resin, an aralkyl type epoxy resin, and other epoxy resins. Among these, an epoxy resin having an alicyclic skeleton and a novolac type epoxy resin are preferable.

### <Epoxy Resin Having Alicyclic Skeleton>

The alicyclic skeleton of the epoxy resin having an alicyclic skeleton is described in the same manner as the alicyclic skeleton of the above-described component (A), and preferred embodiments thereof are also the same.

The epoxy resin having an alicyclic skeleton is preferably an epoxy resin represented by the following general formula (A-2).

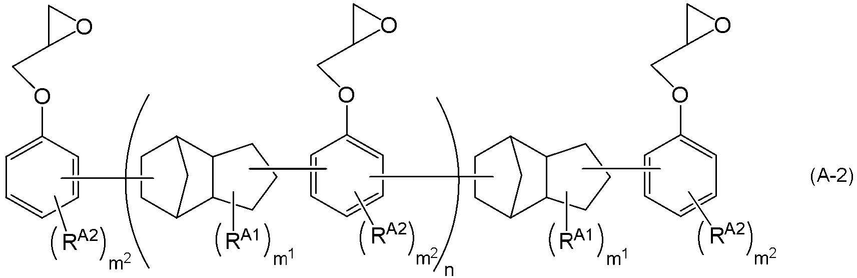

In the formula, R^{A1} represents an alkyl group having 1 to 12 carbon atoms, and may be substituted at any position in the alicyclic skeleton; R^{A2} represents an alkyl group having 1 to 12 carbon atoms; m¹ is an integer of 0 to 6, and m² is an integer of 0 to 3; and n is a number of 0 to 50.

In the general formula (A-2), R^{A1} is the same as R^{A1} in the general formula (A-1), and preferred embodiments thereof are also the same.

In the general formula (A-2), examples of the alkyl group having 1 to 12 carbon atoms represented by R^{A2} include a methyl group, an ethyl group, a n-propyl group, an isopropyl group, a n-butyl group, an isobutyl group, a t-butyl group, and a n-pentyl group. The alkyl group is preferably an alkyl group having 1 to 6 carbon atoms, more preferably an alkyl group having 1 to 3 carbon atoms, and still more preferably a methyl group.

In the general formula (A-2), m¹ is the same as m¹ in the general formula (A-1), and preferred embodiments thereof are also the same.

In the general formula (A-2), m² is an integer of 0 to 3, preferably 0 or 1, and more preferably 0.

In the general formula (A-2), n represents a number of repetitions of the structural unit in the parentheses, and is a number of 0 to 50. In general, the epoxy resin is a mixture of those having different numbers of repetitions of the structural unit in the parentheses, and in this case, n is represented by an average value of the mixture. n is preferably a number of 0 to 30.

As the epoxy resin having an alicyclic skeleton, a commercially available product may be used, and examples of the commercially available product include XD-1000 (trade name, manufactured by Nippon Kayaku Co., Ltd.), and EPICLON (registered trademark) HP-7200 (trade name, manufactured by DIC Corporation).

### <Novolac type Epoxy Resin>

Examples of the novolac type epoxy resin include bisphenol novolac type epoxy resins such as bisphenol A novolac type epoxy resin, bisphenol F novolac type epoxy resin, and bisphenol S novolac type epoxy resin; and phenol novolac type epoxy resins, cresol novolac type epoxy resins, biphenyl novolac type epoxy resins, and naphthol novolac type epoxy resins.

As the novolac type epoxy resin, an epoxy resin having a structural unit represented by the following general formula (A-3) is preferable.

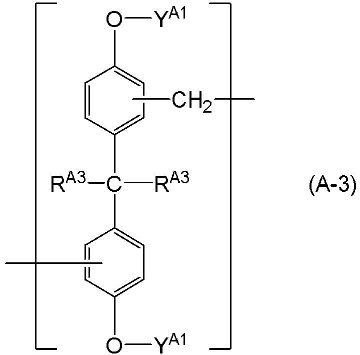

In the formula, R^{A3} represents a hydrogen atom or a methyl group, Y^{A1} each independently represents a hydrogen atom or a glycidyl group; two R^{A3}'s may be the same as or different from each other; and at least one of two Y^{A1}'s represents a glycidyl group.

From the viewpoint of the resolution of a via and the adhesive strength with copper plating, it is preferable that each of the two R^{A3}'s is a hydrogen atom. Further, from the same viewpoint, it is preferable that each of the two Y^{A1}'s is a glycidyl group.

The number of structural units in the epoxy resin (a1) having a structural unit represented by the general formula (A-3) is 1 or more, preferably 10 to 100, more preferably 13 to 80, and still more preferably 15 to 70. When the number of structural units is within the above range, the adhesive strength with copper plating, the heat resistance, and the insulating reliability tend to be improved.

In the general formula (A-3), when each of the two R^{A3}'s is a hydrogen atom and each of the two Y^{A1}'s is a glycidyl group, it is commercially available as EXA-7376 series (trade name, manufactured by DIC Corporation). In addition, when each of the two R^{A3}'s is a methyl group and each of the two Y^{A1}'s is a glycidyl group, it is commercially available as EPON SU8 series (trade name, manufactured by Mitsubishi Chemical Corporation).

Examples of the bisphenol type epoxy resin include a bisphenol A type epoxy resin, a bisphenol F type epoxy resin, a bisphenol S type epoxy resin, and 3,3',5,5'-tetramethyl-4,4'-diglycidyloxydiphenylmethane.

Examples of the aralkyl type epoxy resin include a phenolaralkyl type epoxy resin, a biphenyl aralkyl type epoxy resin, and a naphtholaralkyl type epoxy resin.

Examples of the other epoxy resin include a stilbene type epoxy resin, a naphthalene skeleton-containing type epoxy resin, a biphenyl type epoxy resin, a dihydroanthracene type epoxy resin, a cyclohexanedimethanol type epoxy resin, a trimethylol type epoxy resin, an alicyclic epoxy resin, an aliphatic chain epoxy resin, a heterocyclic epoxy resin, a spiro-ring-containing epoxy resin, and a rubber-modified epoxy resin.

### ((a2) Ethylenically Unsaturated Group-Containing Organic Acid)

As the ethylenically unsaturated group-containing organic acid (a2), an ethylenically unsaturated group-containing monocarboxylic acid is preferable.

Examples of the ethylenically unsaturated group of the component (a2) include the same groups as those listed as the ethylenically unsaturated group of the component (A).

Examples of the component (a2) include acrylic acid derivatives such as acrylic acid, a dimer of acrylic acid, methacrylic acid, β-furfuryl acrylic acid, β-styryl acrylic acid, cinnamic acid, crotonic acid, and α-cyanocinnamic acid; a half-ester compound which is a reaction product of a hydroxy group-containing acrylate and a dibasic acid anhydride; and a half-ester compound which is a reaction product of a vinyl group-containing monoglycidyl ether or a vinyl group-containing monoglycidyl ester and a dibasic acid anhydride.

The component (a2) may be used alone or may be used in combination of two or more types.

The half-ester compound is obtained by reacting one or more ethylenically unsaturated group-containing compounds selected from the group consisting of hydroxy group-containing acrylates, vinyl group-containing monoglycidyl ethers, and vinyl group-containing monoglycidyl esters with a dibasic acid anhydride. In the reaction, the ethylenically unsaturated group-containing compound and the dibasic acid anhydride are preferably reacted in equimolar amounts.

Examples of the hydroxy group-containing acrylate used for the synthesis of the half-ester compound include hydroxyethyl (meth)acrylate, hydroxypropyl (meth)acrylate, hydroxybutyl (meth)acrylate, polyethylene glycol mono(meth)acrylate, trimethylolpropane di(meth)acrylate, pentaerythritol tri(meth)acrylate, and dipentaerythritol penta(meth)acrylate.

Examples of the vinyl group-containing monoglycidyl ether include glycidyl (meth)acrylate.

The dibasic acid anhydride used for the synthesis of the half-ester compound may be one containing a saturated group or one containing an unsaturated group. Examples of the dibasic acid anhydride include succinic anhydride, maleic anhydride, tetrahydrophthalic anhydride, phthalic anhydride, methyltetrahydrophthalic anhydride, ethyltetrahydrophthalic anhydride, hexahydrophthalic anhydride, methylhexahydrophthalic anhydride, ethylhexahydrophthalic anhydride, and itaconic anhydride.

In the reaction between the component (a1) and the component (a2), the amount of the component (a2) to be used is preferably 0.6 to 1.05 equivalents, more preferably 0.7 to 1.02 equivalents, and still more preferably 0.8 to 1.0 equivalents, with respect to 1 equivalent of the epoxy group of the component (a1). By reacting the component (a1) with the component (a2) at the above-described ratio, the photopolymerization property of the component (A) is improved, and the resolution of the via of the obtained photosensitive resin composition tends to be improved.

It is preferable that the component (a1) and the component (a2) are dissolved in an organic solvent and reacted.

Examples of the organic solvent include ketones such as methyl ethyl ketone and cyclohexanone; aromatic hydrocarbons such as toluene, xylene, and tetramethylbenzene; glycol ether compounds such as methyl cellosolve, butyl cellosolve, methyl carbitol, butyl carbitol, propylene glycol monomethyl ether, dipropylene glycol monoethyl ether, dipropylene glycol diethyl ether, and triethylene glycol monoethyl ether; esters such as ethyl acetate, butyl acetate, butyl cellosolve acetate, and carbitol acetate; aliphatic hydrocarbons such as octane and decane; and petroleum-based solvents such as petroleum ether, petroleum naphtha, hydrogenated petroleum naphtha, and solvent naphtha. The organic solvent may be used alone or may be used in combination of two or more types.

A catalyst for accelerating the reaction is preferably used for the reaction of the component (a1) and the component (a2). Examples of the catalyst include amine-based catalysts such as triethylamine and benzylmethylamine; quaternary ammonium salt catalysts such as methyltriethylammonium chloride, benzyltrimethylammonium chloride, benzyltrimethylammonium bromide, and benzyltrimethylammonium iodide; and phosphine-based catalysts such as triphenylphosphine. Among these, phosphine-based catalysts are preferable, and triphenylphosphine is more preferable. The catalyst may be used alone or may be used in combination of two or more types.

In a case where the catalyst is used, the amount thereof to be used is preferably 0.01 to 10 parts by mass, more preferably 0.05 to 5 parts by mass, and still more preferably 0.1 to 2 parts by mass with respect to 100 parts by mass of the total amount of the component (a1) and the component (a2) from the viewpoint of obtaining an appropriate reaction rate.

In the reaction between the component (a1) and the component (a2), it is preferable to use a polymerization inhibitor for the purpose of preventing polymerization during the reaction. Examples of the polymerization inhibitor include hydroquinone, methylhydroquinone, hydroquinone monomethyl ether, catechol, and pyrogallol. The polymerization inhibitor may be used alone or may be used in combination of two or more types.

In a case where the polymerization inhibitor is used, the amount thereof to be used is preferably 0.01 to 1 part by mass, more preferably 0.02 to 0.8 parts by mass, and still more preferably 0.1 to 0.5 parts by mass with respect to 100 parts by mass of the total amount of the component (a1) and the component (a2).

The reaction temperature between the component (a1) and the component (a2) is preferably 60 to 150°C, more preferably 80 to 120°C, and still more preferably 90 to 110°C, from the viewpoint of making the reaction proceed homogeneously while obtaining a sufficient reactivity.

As described above, when the ethylenically unsaturated group-containing monocarboxylic acid is used as the component (a2), the component (A') obtained by reacting the component (a1) and the component (a2) has a hydroxy group formed by a ring-opening addition reaction of the epoxy group of the component (a1) and the carboxy group of the component (a2). Next, the component (a3) is further reacted with the component (A'), whereby an acid-modified vinyl group-containing epoxy resin in which the hydroxy groups of the component (A') (including the hydroxy groups originally present in the component (a1)) and the acid anhydride groups of the component (a3) are half-esterified can be obtained.

### ((a3) Saturated Group- or Unsaturated Group-Containing Polybasic Anhydride)

The component (a3) may be one containing a saturated group or one containing an unsaturated group. Examples of the component (a3) include succinic anhydride, maleic anhydride, tetrahydrophthalic anhydride, phthalic anhydride, methyltetrahydrophthalic anhydride, ethyltetrahydrophthalic anhydride, hexahydrophthalic anhydride, methylhexahydrophthalic anhydride, ethylhexahydrophthalic anhydride, and itaconic anhydride. Among these, tetrahydrophthalic anhydride is preferable from the viewpoint of the resolution of a via. The component (a3) may be used alone or may be used in combination of two or more types.

In the reaction between the component (A') and the component (a3), for example, the acid value of the acid-modified vinyl group-containing epoxy resin can be adjusted by reacting 0.1 to 1.0 equivalents of the component (a3) with respect to 1 equivalent of the hydroxy group in the component (A').

The reaction temperature between the component (A') and the component (a3) is preferably 50 to 150°C, more preferably 60 to 120°C, and still more preferably 70 to 100°C, from the viewpoint of making the reaction proceed homogeneously while obtaining a sufficient reactivity.

The content of the component (A) in the photosensitive resin composition of the present embodiment is not particularly limited, but is preferably 5 to 80% by mass, more preferably 10 to 60% by mass, still more preferably 12 to 50% by mass, particularly preferably 15 to 45% by mass, and most preferably 20 to 40% by mass, based on the total amount of the resin components in the photosensitive resin composition, from the viewpoint of heat resistance, dielectric characteristics, and chemical resistance.

### <(B) Block Isocyanate Compound Having Molecular Weight of 3,000 or Less>

The component (B) is a block isocyanate compound having a molecular weight of 3,000 or less.

Here, the "molecular weight" of a compound in the description herein means a molecular weight that can be calculated from the structural formula when the compound is not a polymer and the structural formula of the compound can be specified, and means a number-average molecular weight (Mn) when the compound is a polymer.

The component (B) may be used alone or may be used in combination of two or more types.

By containing the component (B), the photosensitive resin composition of the present embodiment can achieve both dielectric characteristics and developability. Although the details of the cause are unknown, it is presumed as follows.

In the cured product of the photosensitive resin composition, a hydroxy group generated in the curing process or an unreacted acidic substituent may remain, and these functional groups become a factor of deteriorating the dielectric dissipation factor (Df). On the other hand, the component (B) contained in the photosensitive resin composition of the present embodiment is heated to dissociate the blocking agent, and the generated isocyanate group reacts with the functional group that deteriorates the dielectric dissipation factor (Df), so that good dielectric characteristics are obtained. Furthermore, since the component (B) contained in the photosensitive resin composition of the present embodiment has a molecular weight of 3,000 or less, it is presumed that the developability is also kept good.

The molecular weight of the component (B) is 3,000 or less, preferably 200 to 2,700, more preferably 350 to 2,500, still more preferably 400 to 2,300, and particularly preferably 600 to 2,000.

When the molecular weight of the component (B) is equal to or less than the upper limit value, the developability of the photosensitive resin composition of the present embodiment tends to be more favorable. On the other hand, when the molecular weight of the component (B) is equal to or greater than the lower limit value, the desmear resistance of the photosensitive resin composition of the present embodiment tends to be more favorable.

From the above viewpoint, the molecular weight of the component (B) may be 1,500 or less, may be 1,200 or less, may be 700 or more, and may be 800 or more.

The dissociation temperature of the component (B) is not particularly limited, but is preferably 80 to 250°C, more preferably 90 to 200°C, still more preferably 100 to 180°C, and particularly preferably 110 to 150°C.

When the dissociation temperature of the component (B) is equal to or higher than the lower limit value, the circuit embeddability of the photosensitive resin film formed from the photosensitive resin composition of the present embodiment tends to be more satisfactory. On the other hand, when the dissociation temperature of the component (B) is equal to or lower than the upper limit value, the effect of reducing the dielectric dissipation factor tends to be more favorably exhibited.

The dissociation temperature of the component (B) means an endothermic peak temperature associated with a deprotection reaction of the block isocyanate compound in differential scanning calorimetry.

The isocyanate compound which is a precursor of the block isocyanate compound (hereinafter, also referred to as "isocyanate compound (b1)") may be a monoisocyanate compound, may be a diisocyanate compound, or may be a polyisocyanate compound having a functionality of three or larger, but is preferably a polyisocyanate compound having a functionality of three or larger, and is more preferably a trifunctional isocyanate compound from the viewpoint of further improving the dielectric characteristics.

The polyisocyanate compound having a functionality of three or larger is preferably a multimer of a diisocyanate compound. The multimer of the diisocyanate compound is preferably a trimer or a tetramer or more, and is more preferably a trimer from the viewpoint of further improving the dielectric characteristics. Note that the trimer of the diisocyanate compound has three isocyanate groups.

As the trimer of the diisocyanate compound, from the viewpoint of further improving the dielectric characteristics, a trifunctional isocyanate compound having a biuret structure in which a diisocyanate compound is trimerized and a trifunctional isocyanate compound in which an isocyanurate ring is formed by trimerizing a diisocyanate compound are preferable, and a trifunctional isocyanate compound in which an isocyanurate ring is formed by trimerizing a diisocyanate compound is more preferable.

That is, from the viewpoint of further improving the dielectric characteristics, the component (B) is preferably a compound containing an isocyanurate ring, and more preferably a compound obtained by blocking a trifunctional isocyanate compound containing an isocyanurate ring with a blocking agent.

Examples of the isocyanate compound (b1) include aliphatic isocyanate compounds and aromatic isocyanate compounds.

In the description herein, the aliphatic isocyanate compound means an isocyanate compound having an isocyanate group directly bonded to an aliphatic group, and the aromatic isocyanate compound means an isocyanate compound having an isocyanate group directly bonded to an aromatic group. A compound having both an isocyanate group directly bonded to an aliphatic group and an isocyanate group directly bonded to an aromatic group is regarded as belonging to both an aliphatic isocyanate compound and an aromatic isocyanate compound.

The aliphatic isocyanate compound also includes an alicyclic isocyanate compound.

Examples of the aliphatic isocyanate compound include aliphatic diisocyanate compounds such as trimethylene diisocyanate, tetramethylene diisocyanate, pentamethylene diisocyanate, hexamethylene diisocyanate, 2,6-diisocyanate methyl caprate, xylylene diisocyanate, 1,3-cyclopentane diisocyanate, 1,3-cyclopentene diisocyanate, 1,4-cyclohexane diisocyanate, 1,3-cyclohexane diisocyanate, 3-isocyanatomethyl-3,5,5-trimethylcyclohexyl isocyanate, methylenebis(cyclohexyl isocyanate), methylcyclohexane diisocyanate, norbornane diisocyanate, bis(isocyanatomethyl)cyclohexane, and isophorone diisocyanate; and multimers of the above-mentioned aliphatic diisocyanate compounds.

Among these, a multimer of an aliphatic diisocyanate compound is preferable, a trimer of an aliphatic diisocyanate compound is more preferable, and a trifunctional isocyanate compound in which hexamethylene diisocyanate is trimerized to form an isocyanurate ring, a trifunctional isocyanate compound in which isophorone diisocyanate is trimerized to form an isocyanurate ring, and a trifunctional isocyanate compound having a biuret structure in which hexamethylene diisocyanate is trimerized are still more preferable.

Examples of the aromatic isocyanate compound include tolylene diisocyanate, phenylene diisocyanate, 1,5-naphthalene diisocyanate, 4,4'-diphenylmethane diisocyanate, 4,4'-toluidine diisocyanate, and 4,4'-diphenyl ether diisocyanate.

Examples of the blocking agent include an oxime-based compound, an alcohol-based compound, an acid amide-based compound, an acid imide-based compound, a phenol-based compound, an amine-based compound, an active methylene-based compound, an imidazole-based compound, and a pyrazole-based compound.

Examples of the oxime-based compound include formaldoxime, acetaldoxime, acetoxime, methyl ethyl ketoxime, 2-butanone oxime, and cyclohexanone oxime.

Examples of the alcohol-based compound include methanol, ethanol, 2-propanol, n-butanol, sec-butanol, 2-ethyl-1-hexanol, 2-methoxyethanol, 2-ethoxyethanol, and 2-butoxyethanol.

Examples of the acid amide-based compound include acetanilide, acetic acid amide, ε-caprolactam, δ-valerolactam, and γ-butyrolactam.

Examples of the acid imide-based compound include succinimide and maleimide.

Examples of the phenol-based compound include phenol, cresol, ethylphenol, butylphenol, nonylphenol, dinonylphenol, styrenated phenol, and hydroxybenzoic acid ester.

Examples of the amine-based compound include diphenylamine, aniline, carbazole, di-n-propylamine, diisopropylamine, and isopropylethylamine.

Examples of the active methylene-based compound include dimethyl malonate, diethyl malonate, methyl acetoacetate, ethyl acetoacetate, and acetylacetone.

Examples of the imidazole-based compound include imidazole and 2-methylimidazole.

Examples of the pyrazole-based compound include pyrazole, 3-methylpyrazole, and 3,5-dimethylpyrazole.

The content of the component (B) in the photosensitive resin composition of the present embodiment is not particularly limited, but is preferably 1 to 40% by mass, more preferably 3 to 35% by mass, still more preferably 5 to 30% by mass, and particularly preferably 6 to 25% by mass, based on the total amount of the resin components in the photosensitive resin composition.

When the content of the component (B) in the photosensitive resin composition of the present embodiment is equal to or greater than the lower limit value, the dielectric characteristics tend to be more favorable. On the other hand, when the content of the component (B) in the photosensitive resin composition of the present embodiment is equal to or less than the upper limit value, the adhesive strength with copper plating tends to be more favorable.

### <(C) Thermosetting Resin>

It is preferable that the photosensitive resin composition of the present embodiment further contains a thermosetting resin as a component (C). The component (C) does not include the component (A).

When the photosensitive resin composition of the present embodiment contains the thermosetting resin (C), there is a tendency that heat resistance is improved in addition to improvement of the adhesive strength with copper plating and the insulating reliability.

As the component (C), one type may be used alone, or two or more types may be used in combination.

Examples of the thermosetting resin (C) include an epoxy resin, a phenol resin, an unsaturated imide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. In addition, the thermosetting resin is not particularly limited thereto, and a known thermosetting resin can be used. Among these, an epoxy resin is preferable from the viewpoint of the adhesive strength with copper plating, the insulating reliability, and the heat resistance.

The epoxy resin is preferably an epoxy resin having two or more epoxy groups. The epoxy resin is classified into a glycidyl ether type epoxy resin, a glycidyl amine type epoxy resin, and a glycidyl ester type epoxy resin. Among these, a glycidyl ether type epoxy resin is preferable.

In addition, epoxy resins are classified into various epoxy resins according to the difference in the main skeleton, and the respective types of epoxy resins are further classified as follows. Specifically, epoxy resins are classified into bisphenol-based epoxy resins such as bisphenol A type epoxy resin, bisphenol F type epoxy resin, and bisphenol S type epoxy resin; bisphenol-based novolac type epoxy resins such as bisphenol A novolac type epoxy resin and bisphenol F novolac type epoxy resin; novolac type epoxy resins other than the above-mentioned bisphenol-based novolac type epoxy resins, such as phenol novolac type epoxy resin, cresol novolac type epoxy resin, and biphenyl novolac type epoxy resin; phenol aralkyl type epoxy resins; stilbene type epoxy resins; naphthalene skeleton-containing epoxy resins such as naphthol novolac type epoxy resin, naphthol type epoxy resin, naphthol aralkyl type epoxy resin, and naphthylene ether type epoxy resin; biphenyl type epoxy resins; biphenyl aralkyl type epoxy resins; xylylene type epoxy resins; dihydroanthracene type epoxy resins; alicyclic epoxy resins such as saturated dicyclopentadiene type epoxy resins; heterocyclic epoxy resins; spiro ring-containing epoxy resins; cyclohexanedimethanol type epoxy resins; trimethylol type epoxy resins; aliphatic chain epoxy resins; and rubber-modified epoxy resins.

Among these, the epoxy resin preferably includes at least one selected from the group consisting of a bisphenol-based epoxy resin, a naphthalene skeleton-containing epoxy resin, and a biphenyl aralkyl type epoxy resin, and more preferably includes at least one selected from the group consisting of a naphthalene skeleton-containing epoxy resin and a biphenyl aralkyl type epoxy resin, particularly from the viewpoint of heat resistance, electrical insulating reliability, developability, and adhesive strength with copper plating.

The equivalent ratio of the epoxy groups of the component (C) to the acidic substituents of the component (A) in the photosensitive resin composition of the present embodiment [epoxy groups/acidic substituents] is not particularly limited, but from the viewpoint of insulating reliability, dielectric characteristics, heat resistance, and adhesive strength with copper plating, it is preferably 0.5 to 6.0, more preferably 0.7 to 4.0, still more preferably 0.8 to 2.0, and particularly preferably 0.9 to 1.8.

When the photosensitive resin composition of the present embodiment contains the thermosetting resin (C), the content of the thermosetting resin (C) is not particularly limited, but from the viewpoint of insulating reliability, dielectric characteristics, heat resistance, and adhesive strength with copper plating, it is preferably 1 to 50% by mass, more preferably 5 to 45% by mass, still more preferably 15 to 40% by mass, and particularly preferably 20 to 35% by mass, based on the total amount of the resin components in the photosensitive resin composition.

### <(D) Photopolymerization Initiator>

It is preferable that the photosensitive resin composition of the present embodiment further contains a photopolymerization initiator as a component (D). The photosensitive resin composition of the present embodiment contains the photopolymerization initiator (D), and thus the resolution of a via tends to be improved.

The photopolymerization initiator (D) may be used alone or may be used in combination of two or more types. From the viewpoint of the resolution of a via, the photosensitive resin composition of the present embodiment preferably contains two or more types of the photopolymerization initiators (D).

The photopolymerization initiator (D) is not particularly limited as long as it can cause photopolymerization of an ethylenically unsaturated group, and can be appropriately selected from commonly used photopolymerization initiators.

Examples of the photopolymerization initiator (D) include benzoin-based compounds such as benzoin, benzoin methyl ether, and benzoin isopropyl ether; acetophenone-based compounds such as acetophenone, 2,2-dimethoxy-2-phenylacetophenone, 2,2-diethoxy-2-phenylacetophenone, 1,1-dichloroacetophenone, 1-hydroxycyclohexyl phenyl ketone, 2-benzyl-2-dimethylamino-1-(4-morpholinophenyl)-1-butanone, 2-[4-(methylthio)benzoyl]-2-(4-morpholinyl)propane, and N,N-dimethylaminoacetophenone; anthraquinone-based compounds such as 2-methylanthraquinone, 2-ethylanthraquinone, 2-tert-butylanthraquinone, 1-chloroanthraquinone, 2-amylanthraquinone, and 2-aminoanthraquinone; ketal-based compounds such as acetophenonedimethylketal and benzyldimethylketal; acridine-based compounds such as 9-phenylacridine and 1,7-bis(9,9'-acridinyl)heptane; acylphosphine oxide-based compounds such as bis(2,4,6-trimethylbenzoyl)phenylphosphine oxide; and oxime ester-based compounds such as 1,2-octanedione-1-[4-(phenylthio)phenyl]-2-(O-benzoyloxime), 1-[9-ethyl-6-(2-methylbenzoyl)-9H-carbazol-3-yl]ethanone 1-(O-acetyloxime), and 1-phenyl-1,2-propanedione-2-[O-(ethoxycarbonyl)oxime].

Among these, oxime ester-based compounds and acylphosphine oxide-based compounds are preferable, and 1-[9-ethyl-6-(2-methylbenzoyl)-9H-carbazol-3-yl]ethanone 1-(O-acetyloxime) and bis(2,4,6-trimethylbenzoyl)phenylphosphine oxide are more preferable. The oxime ester-based compound has an advantage of improving photocurability, and the acylphosphine oxide-based compound has an advantage of improving the degree of curing at the bottom of a cured product obtained by curing the photosensitive resin film and suppressing undercutting. By using the oxime ester-based compound and the acylphosphine oxide-based compound in combination, the resolution of a via tends to be further enhanced.

When the photosensitive resin composition of the present embodiment contains the photopolymerization initiator (D), the content of the photopolymerization initiator (D) is not particularly limited, but from the viewpoint of easily obtaining an appropriate polymerization reaction promoting effect, the content is preferably 0.01 to 20% by mass, more preferably 0.02 to 10% by mass, still more preferably 0.03 to 3% by mass, and particularly preferably 0.05 to 1% by mass, based on the total amount of the resin components in the photosensitive resin composition.

### <(E) Crosslinking Agent>

It is preferable that the photosensitive resin composition of the present embodiment further contains a crosslinking agent as a component (E). As the crosslinking agent, a crosslinking agent having two or more ethylenically unsaturated groups and not having an acidic substituent is preferable. The crosslinking agent increases the crosslinking density of the photosensitive resin film after curing by reacting with the ethylenically unsaturated group of the component (A). Therefore, the photosensitive resin composition of the present embodiment tends to have improved heat resistance and dielectric characteristics by containing the crosslinking agent.

The crosslinking agent (E) may be used alone or may be used in combination of two or more types.

Examples of the crosslinking agent (E) include a bifunctional monomer having two ethylenically unsaturated groups and a polyfunctional monomer having three or more ethylenically unsaturated groups. The crosslinking agent (E) preferably contains the above-described polyfunctional monomer.

The ethylenically unsaturated group contained in the crosslinking agent (E) may be the same as the ethylenically unsaturated group contained in the component (A), and preferred embodiments thereof are also the same.

Examples of the bifunctional monomer include aliphatic di(meth)acrylates such as trimethylolpropane di(meth)acrylate, polypropylene glycol di(meth)acrylate, and polyethylene glycol di(meth)acrylate; di(meth)acrylates having an alicyclic skeleton, such as dicyclopentadiene di(meth)acrylate and tricyclodecane dimethanol di(meth)acrylate; and aromatic di(meth)acrylates such as 2,2-bis(4-(meth)acryloxypolyethoxypolypropoxyphenyl)propane, and bisphenol A diglycidyl ether di(meth)acrylate.

Among these, from the viewpoint of obtaining more excellent dielectric characteristics, di(meth)acrylate having an alicyclic skeleton is preferable, and tricyclodecane dimethanol diacrylate is more preferable.

Examples of the polyfunctional monomer include (meth)acrylate compounds having a skeleton derived from trimethylolpropane, such as trimethylolpropane tri(meth)acrylate; (meth)acrylate compounds having a skeleton derived from tetramethylolmethane, such as tetramethylolmethane tri(meth)acrylate and tetramethylolmethane tetra(meth)acrylate; (meth)acrylate compounds having a skeleton derived from pentaerythritol, such as pentaerythritol tri(meth)acrylate and pentaerythritol tetra(meth)acrylate; (meth)acrylate compounds having a skeleton derived from dipentaerythritol, such as dipentaerythritol penta(meth)acrylate and dipentaerythritol hexa(meth)acrylate; (meth)acrylate compounds having a skeleton derived from ditrimethylolpropane, such as ditrimethylolpropane tetra(meth)acrylate; and (meth)acrylate compounds having a skeleton derived from diglycerin. Among these, from the viewpoint of the resolution of a via and the adhesive strength with copper plating, a (meth)acrylate compound having a skeleton derived from dipentaerythritol is preferable, and dipentaerythritol hexa(meth)acrylate is more preferable.

Here, the above-described "(meth)acrylate compound having a skeleton derived from XXX" (in which XXX is a compound name) means an esterified product of XXX and (meth)acrylic acid, and the esterified product also includes a compound modified with an alkyleneoxy group.

When the photosensitive resin composition of the present embodiment contains the crosslinking agent (E), the content of the crosslinking agent (E) is not particularly limited, but is preferably 10 to 85 parts by mass, more preferably 25 to 80 parts by mass, still more preferably 35 to 75 parts by mass, and particularly preferably 45 to 70 parts by mass, with respect to 100 parts by mass of the component (A), from the viewpoint of heat resistance and dielectric characteristics.

### <(F) Elastomer>

It is preferable that the photosensitive resin composition of the present embodiment further contains an elastomer as a component (F). The photosensitive resin composition of the present embodiment tends to have improved adhesive strength with copper plating by containing the elastomer (F).

The elastomer (F) may be used alone or may be used in combination of two or more types.

The elastomer (F) may have a reactive functional group at a molecular terminal or in a molecular chain.

Examples of the reactive functional group include an acid anhydride group, an epoxy group, a hydroxy group, a carboxy group, an amino group, an amide group, an isocyanato group, an acrylic group, a methacrylic group, and a vinyl group. Among these, an acid anhydride group is preferable from the viewpoint of the resolution of a via and the adhesive strength with copper plating. As the acid anhydride group, an acid anhydride group derived from maleic anhydride is preferable.

When the elastomer (F) has an acid anhydride group, the number of acid anhydride groups in one molecule is preferably 1 to 10, more preferably 3 to 10, and still more preferably 6 to 10 from the viewpoint of the resolution of a via and the dielectric characteristics.

Examples of the elastomer (F) include polybutadiene-based elastomers, polyester-based elastomers, styrene-based elastomers, olefin-based elastomers, urethane-based elastomers, polyamide-based elastomers, acrylic-based elastomers, silicone-based elastomers, and derivatives of these elastomers. Among these, a polybutadiene-based elastomer is preferable from the viewpoint of improvement in adhesive strength with copper plating and further improvement in compatibility and solubility with a resin component. From the viewpoint of the resolution of a via, the polybutadiene-based elastomer is preferably a polybutadiene-based elastomer having an acid anhydride group which is modified with an acid anhydride, and more preferably a polybutadiene-based elastomer having an acid anhydride group derived from maleic anhydride.

The polybutadiene-based elastomer may be a polybutadiene having an epoxy group [hereinafter, sometimes referred to as epoxidized polybutadiene] from the viewpoint of the adhesive strength with copper plating.

The epoxidized polybutadiene is preferably an epoxidized polybutadiene represented by the following general formula (F-1) from the viewpoint of the adhesive strength with copper plating and the flexibility.

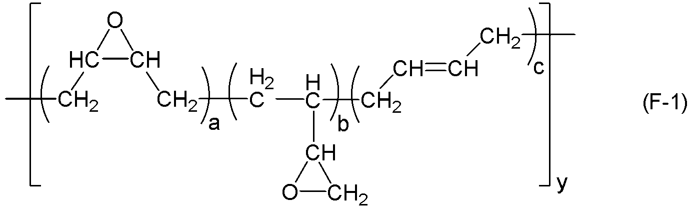

In the formula, a, b and c each represent a ratio of structural units in parentheses, in which a is 0.05 to 0.40, b is 0.02 to 0.30, c is 0.30 to 0.80, and further a + b + c = 1.00 and (a + c) > b are satisfied; and y represents the number of structural units in a bracket and is an integer of 10 to 250.

In the general formula (F-1), the bonding order of each structural unit in the bracket is not specified. That is, the structural unit shown on the left, the structural unit shown in the center, and the structural unit shown on the right may be interchanged, and when they are represented by (a), (b), and (c), respectively, there can be various bonding orders such as -[(a)-(b)-(c)]-[(a)-(b)-(c)-]-, -[(a)-(c)-(b)]-[(a)-(c)-(b)-]-, -[(b)-(a)-(c)]-[(b)-(a)-(c)-]-, -[(a)-(b)-(c)]-[(c)-(b)-(a)-]-, -[(a)-(b)-(a)]-[(c)-(b)-(c)-]-, and -[(c)-(b)-(c)]-[(b)-(a)-(a)-]-.

From the viewpoint of the adhesive strength with copper plating and the flexibility, a is preferably 0.10 to 0.30, b is preferably 0.10 to 0.30, and c is preferably 0.40 to 0.80. From the same viewpoint, y is preferably an integer of 30 to 180.

The number-average molecular weight (Mn) of the elastomer (F) is not particularly limited, but is preferably 10,000 to 80,000, may be 20,000 to 70,000, may be 30,000 to 65,000, and may be 40,000 to 60,000.

When the photosensitive resin composition of the present embodiment contains the elastomer (F), the content of the elastomer (F) is not particularly limited, but is preferably 0.5 to 15% by mass, more preferably 1 to 14% by mass, still more preferably 3 to 13% by mass, and particularly preferably 5 to 12% by mass, based on the total amount of the resin components in the photosensitive resin composition, from the viewpoint of the heat resistance and the adhesive strength with copper plating.

### <(G) Inorganic Filler>

It is preferable that the photosensitive resin composition of the present embodiment further contains an inorganic filler as a component (G).

By containing the inorganic filler (G), the photosensitive resin composition of the present embodiment tends to have better low thermal expansion properties, heat resistance, and flame retardancy.

The inorganic filler (G) may be used alone or in combination of two or more types.

Examples of the inorganic filler (G) include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay, molybdic acid compound, talc, aluminum borate, and silicon carbide. Among these, as the inorganic filler, silica and alumina are preferable, and silica is more preferable, from the viewpoint of thermal expansion coefficient, heat resistance, and flame retardancy. Examples of the silica include crushed silica, fumed silica, and fused silica.

The volume-average particle diameter (D₅₀) of the inorganic filler (G) is not particularly limited, but is preferably 0.01 to 20 µm, more preferably 0.1 to 10 µm, still more preferably 0.2 to 1 µm, and particularly preferably 0.3 to 0.8 µm.

In the description herein, the volume-average particle diameter (D₅₀) can be obtained as a particle diameter corresponding to an integrated value of 50% (volume-based) in a particle size distribution by measuring particles dispersed in a solvent at a refractive index of 1.38 in accordance with International Standard ISO13321 using a submicron particle analyzer (trade name: N5, manufactured by Beckman Coulter, Inc.).

When the photosensitive resin composition of the present embodiment contains the inorganic filler (G), the content of the inorganic filler (G) is preferably 1 to 70% by mass, more preferably 5 to 60% by mass, still more preferably 15 to 55% by mass, and particularly preferably 25 to 50% by mass, based on the total solids content of the photosensitive resin composition, from the viewpoint of forming an interlayer insulating layer having more excellent low thermal expansion properties, heat resistance, flame retardancy, and conductor adhesion.

### <(H) Curing Accelerator>

It is preferable that the photosensitive resin composition of the present embodiment further contains a curing accelerator as a component (H).

By containing the curing accelerator (H), the photosensitive resin composition of the present embodiment tends to have more satisfactory heat resistance and dielectric characteristics.

The curing accelerator (H) may be used alone or may be used in combination of two or more types.

Examples of the curing accelerator (H) include imidazole-based compounds such as 2-methylimidazole, 2-ethyl-4-methylimidazole, 1-benzyl-2-methylimidazole, 2-phenylimidazole, 2-phenyl-1-benzyl-1H-imidazole, 2-phenyl-4-methyl-5-hydroxymethylimidazole, and isocyanate-masked imidazole (addition reaction product of hexamethylene diisocyanate resin and 2-ethyl-4-methylimidazole); tertiary amines such as trimethylamine, N,N-dimethyloctylamine, N-benzyldimethylamine, pyridine, N-methylmorpholine, hexa(N-methyl)melamine, 2,4,6-tris(dimethylaminophenol), tetramethylguanidine, and m-aminophenol; organic phosphines such as tributylphosphine, triphenylphosphine, and tris-2-cyanoethylphosphine; phosphonium salts such as tri-n-butyl(2,5-dihydroxyphenyl)phosphonium bromide and hexadecyltributyl phosphonium chloride; quaternary ammonium salts such as benzyltrimethylammonium chloride and phenyltributylammonium chloride; the above-mentioned polybasic acid anhydrides; and diphenyliodonium tetrafluoroborate, triphenylsulfonium hexafluoroantimonate, and 2,4,6-triphenylthiopyrylium hexafluorophosphate.

Among these, imidazole-based compounds are preferable from the viewpoint of obtaining an excellent curing action.

When the photosensitive resin composition of the present embodiment contains the curing accelerator (H), the content of the curing accelerator (H) is not particularly limited, but is preferably 0.01 to 10% by mass, more preferably 0.05 to 5% by mass, and still more preferably 0.1 to 2% by mass, based on the total amount of the resin components in the photosensitive resin composition, from the viewpoint of improving heat resistance and dielectric characteristics.

### <(I) Other Component>

The photosensitive resin composition of the present embodiment may contain other components (I) as necessary.

Examples of the other components (I) include resins other than the above-described components; a curing agent; an organic filler; a photosensitizer; a polymerization inhibitor; a foam stabilizer; a pigment; an adhesive aid such as melamine; a foam stabilizer such as a silicone compound; a thickener; a flame retardant; and an organic solvent.

For each of these, one type may be used alone, or two or more types may be used in combination.

The content of the other component (I) in the photosensitive resin composition of the present embodiment may be appropriately adjusted according to each purpose, and may be 0.01 to 10% by mass, 0.05 to 5% by mass, or 0.1 to 1% by mass, based on the total solid content of the photosensitive resin composition.

### <Method for Producing Photosensitive Resin Composition>

The photosensitive resin composition of the present embodiment can be obtained by kneading and mixing the respective components with a roll mill or a bead mill.

### [Photosensitive Resin Film]

The photosensitive resin film of the present embodiment includes the photosensitive resin composition of the present embodiment. The photosensitive resin film is useful as a photosensitive layer for forming an interlayer insulating layer.

Each component and the content thereof in the photosensitive resin film of the present embodiment are as described for each component and the content thereof in the photosensitive resin composition of the present embodiment.

The photosensitive resin film of the present embodiment may be provided on a carrier film.

Examples of the carrier film include polyesters such as polyethylene terephthalate and polybutylene terephthalate; and polyolefins such as polypropylene and polyethylene. The thickness of the carrier film is preferably 5 to 100 µm, more preferably 10 to 60 µm, and still more preferably 15 to 45 µm.

In addition, the photosensitive resin film of the present embodiment may have a protective film on the surface opposite to the surface in contact with the carrier film.

The photosensitive resin film of the present embodiment can be formed by, for example, applying the photosensitive resin composition of the present embodiment onto a carrier film with a known coating apparatus such as a comma coater, a bar coater, a kiss coater, a roll coater, a gravure coater, or a die coater, and drying the photosensitive resin composition.

For the drying of the coating film formed by applying the photosensitive resin composition, hot air drying, a dryer using far infrared rays or near infrared rays can be used. The drying temperature is preferably 60 to 150°C, more preferably 70 to 120°C, and still more preferably 80 to 110°C. Further, the drying time is preferably 1 to 60 minutes, more preferably 2 to 30 minutes, and still more preferably 5 to 20 minutes. The content of the residual diluent in the photosensitive resin film after drying is preferably 3% by mass or less, more preferably 2% by mass or less, and still more preferably 1% by mass or less, from the viewpoint of avoiding diffusion of the diluent in the step of producing a printed wiring board.

The thickness of the photosensitive resin film of the present embodiment is not particularly limited, but is preferably 1 to 100 µm, more preferably 3 to 60 µm, and still more preferably 5 to 40 µm, from the viewpoint of thinning a printed wiring board.

### [Printed Wiring Board]

The printed wiring board of the present embodiment is a printed wiring board having a cured product of the photosensitive resin composition of the present embodiment.

The printed wiring board of the present embodiment is preferably a printed wiring board having an interlayer insulating layer which is a cured product of the photosensitive resin film of the present embodiment.

Here, the "interlayer insulating layer" of in the printed wiring board of the present embodiment also includes, for example, an interlayer insulating layer in a state after being subjected to various processes or treatments such as formation of a via and a wiring, and a roughening treatment.

The method for producing a printed wiring board of the present embodiment is not particularly limited as long as it is a method using the photosensitive resin film of the present embodiment, but a method for producing a printed wiring board including the following (1) to (4) is preferable.
(1) The photosensitive resin film of the present embodiment is laminated on one surface or both surfaces of a circuit board (hereinafter, also referred to as "lamination step (1)").
(2) The photosensitive resin film laminated in (1) is exposed and developed to form an interlayer insulating layer having a via (hereinafter, also referred to as "via forming step (2)").
(3) The interlayer insulating layer having the via is heated and cured (hereinafter, also referred to as "heating and curing step (3)").
(4) A circuit pattern is formed on the interlayer insulating layer (hereinafter, also referred to as "circuit pattern forming step (4)").

Hereinafter, the method for producing a printed wiring board of the present embodiment will be described with reference to Fig. 1 as appropriate.

In the description herein, for the sake of convenience, a predetermined operation may be referred to as "XX step", but the "XX step" is not limited to the embodiment specifically described in the description herein.

### (Lamination Step (1))

In the lamination step (1), the photosensitive resin film of the present embodiment is laminated on one surface or both surfaces of a circuit board.

Fig. 1(a) illustrates a process of forming a photosensitive layer 103 on both surfaces of a substrate 101 having a circuit pattern 102.

The photosensitive layer 103 can be formed by laminating the photosensitive resin film of the present embodiment on both surfaces of the substrate 101 such that the second surface serves as an attachment surface.

The lamination may be performed, for example, by press-bonding using a vacuum laminator while applying pressure and heat.

In a case where a carrier film is attached to the photosensitive layer 103 after the lamination, the carrier film may be peeled off before the exposure described later or may be peeled off after the exposure.

### (Via Forming Step (2))

In the via forming step (2), an interlayer insulating layer having a via is formed by exposing and developing the photosensitive layer formed in the lamination step (1).

Fig. 1(b) illustrates a process of forming an interlayer insulating layer 104 having a via 105 by exposing and developing the photosensitive layer 103.

By exposing the photosensitive layer 103, a photoradical polymerization reaction is initiated and the photosensitive resin film is cured.

The exposure method of the photosensitive layer 103 may be, for example, a mask exposure method of irradiating an active ray in an image shape through a negative or positive mask pattern called artwork, or a method of irradiating an active ray in an image shape by a direct drawing exposure method such as a laser direct imaging (LDI) exposure method or a digital light processing (DLP) exposure method.

Examples of the light source of the active ray include known light sources such as gas lasers such as a carbon arc lamp, a mercury vapor arc lamp, a high-pressure mercury lamp, a xenon lamp, and an argon laser; solid lasers such as a YAG laser; and semiconductor lasers which effectively emit ultraviolet rays or visible rays.

The exposure amount may be appropriately adjusted depending on the light source used, and the thickness of the photosensitive layer. For example, when a photosensitive layer having a thickness of 1 to 100 µm is exposed to ultraviolet radiation from a high-pressure mercury lamp, the exposure amount is not particularly limited, but is preferably 10 to 1,000 mJ/cm², more preferably 50 to 700 mJ/cm², and still more preferably 150 to 400 mJ/cm².

Subsequently, when a carrier film is present on the photosensitive layer 103, the carrier film is removed, and then development is performed. In the development, an uncured portion of the photosensitive layer 103 is removed, and thus a photocured portion is formed on the substrate as the interlayer insulating layer 104.

The developing method may be wet development or dry development, but wet development is preferred. As the method by wet development, a spray system is preferred from the viewpoint of improving resolution.

Examples of the developing solution include an alkaline aqueous solution, a water-based developing solution, and an organic solvent-based developing solution, and among these, an alkaline aqueous solution is preferable.

After exposure and development, post-exposure may be performed from the viewpoint of increasing the degree of curing of the interlayer insulating layer. The exposure amount in the post-exposure is not particularly limited, but is preferably 0.2 to 10 J/cm², and more preferably 0.5 to 5 J/cm².

The shape of the via is not particularly limited, and examples of the cross-sectional shape include a quadrangular shape and an inverted trapezoidal shape. The inverted trapezoidal shape has an upper side longer than a lower side. The shape of the via in plan view includes a circular shape and a quadrangular shape.

In the formation of a via by the photolithography method of the present embodiment, a via having an inverted trapezoidal cross-sectional shape can be formed. The via having such a shape is preferable because plated copper has high throwing power to the wall surface of the via.

In the formation of the via by the photolithography method of the present embodiment, the diameter of the via can be made smaller than the diameter of the via formed by laser processing. The diameter of the via formed by the production method of the present embodiment may be, for example, 40 µm or less, may be 35 µm or less, or may be 30 µm or less. The lower limit value of the diameter of the via is not particularly limited, and may be, for example, 15 µm or more, or may be 20 µm or more.

### (Heating and Curing Step (3))

In the heating and curing step (3), the interlayer insulating layer having the via is heated and cured.

That is, in the heating and curing step (3), the curing reaction of the component having a thermosetting property contained in the photosensitive resin film of the present embodiment is allowed to proceed by heating.

The heating temperature is not particularly limited, but is preferably 100 to 300°C, more preferably 120 to 200°C, and still more preferably 150 to 180°C. The heating time is not particularly limited, but is preferably 0.3 to 3 hours, more preferably 0.5 to 2 hours, and still more preferably 0.75 to 1.5 hours.

### (Circuit Pattern Forming Step (4))

Next, a circuit pattern is formed on the interlayer insulating layer formed as described above.

The circuit pattern is preferably formed by a semi-additive process in which a roughening treatment, formation of a seed layer, formation of a resist pattern, formation of a copper circuit layer, and removal of the resist pattern are performed in this order from the viewpoint of forming fine wiring.

The roughening treatment is a treatment for roughening the surface of the interlayer insulating layer to form an uneven anchor. When a smear is generated in the via forming step (2), the roughening treatment and the removal of the smear may be simultaneously performed using a roughening solution. Examples of the roughening solution include an alkaline permanganate roughening solution such as a sodium permanganate roughening solution; a chromium/sulfuric acid roughening solution, and a sodium fluoride/chromium/sulfuric acid roughening solution.

Fig. 1(c) illustrates a process of forming a seed layer 106.

The seed layer 106 is for forming a power supply layer for performing electrolytic copper plating.

The seed layer 106 can be formed by performing an electroless copper plating treatment on the via bottom, the via wall surface, and the entire surface of the interlayer insulating layer using a palladium catalyst.

Fig. 1(d) illustrates a process of forming a resist pattern 107 on the seed layer 106.

The resist pattern 107 can be formed by, for example, thermocompression bonding a dry film resist on the seed layer 106 using a roll laminator, and exposing and developing the dry film resist. As the dry film resist, a commercially available product can be used.

The exposure of the dry film resist may be performed through a mask on which a desired wiring pattern is drawn. After the exposure, the dry film resist is developed using an alkaline aqueous solution to remove an unexposed portion, thereby forming a resist pattern 107. Thereafter, a plasma treatment for removing a development residue of the dry film resist may be performed as necessary.

Fig. 1(e) illustrates a process of forming a copper circuit layer 108.

The copper circuit layer 108 is preferably formed by electrolytic copper plating.

As the electrolytic copper plating solution used for electrolytic copper plating, for example, a commercially available electrolytic copper plating solution such as an electrolytic copper plating solution containing copper sulfate can be used.

After the electrolytic copper plating, the resist pattern 107 is removed by using an alkaline aqueous solution or an amine-based peeling agent, and flash etching for removing the seed layer 106 between the wirings, and removal of a palladium catalyst are appropriately performed by a known method. Further, if necessary, a post-baking treatment for sufficiently thermally curing the unreacted thermosetting component may be performed.

Fig. 1(f) shows a multilayer printed wiring board 100A which is multilayered by repeating the above processes and has a solder resist layer 109 on the outermost layer.

The solder resist layer 109 can be formed by using a known photosensitive resin film for solder resist.

The method for producing a printed wiring board in which a via is formed using the photosensitive resin film of the present embodiment has been described above. Since the photosensitive resin film of the present embodiment has excellent pattern resolution, the photosensitive resin film of the present embodiment is also suitable for forming, for example, a cavity for embedding a chip or a passive element. The cavity can be suitably formed, for example, by using a drawing pattern capable of forming a desired cavity when the photosensitive resin film is exposed to form a pattern in the description of the printed wiring board described above.

### [Semiconductor Package]

The semiconductor package of the present embodiment is a semiconductor package having the printed wiring board of the present embodiment and a semiconductor element.

The semiconductor package of the present embodiment can be produced, for example, by mounting a semiconductor element such as a semiconductor chip or a memory on a predetermined position of the printed wiring board of the present embodiment and sealing the semiconductor element with a sealing resin.

### Examples

Hereinafter, the present embodiment will be described in more detail with reference to Examples, but the present embodiment is not limited to these Examples.

### [Measurement Method of Acid Value]

The acid value was calculated from the amount of a potassium hydroxide aqueous solution required to neutralize a measurement target.

### [Measurement Method of Weight-Average Molecular Weight (Mw)]

The weight-average molecular weight (Mw) was measured with the following GPC measurement apparatus under the following measurement conditions, and was determined by conversion using a calibration curve of standard polystyrene. For the preparation of the calibration curve, 5 sample sets ("PStQuick MP-H" and "PStQuick B", manufactured by Tosoh Corporation) were used as the standard polystyrene.

### (GPC Measurement Apparatus)

GPC apparatus: high-speed GPC apparatus "HCL-8320GPC", detector is differential refractometer or UV, manufactured by Tosoh Corporation
Column: column TSKgel SuperMultipore HZ-H (column length: 15 cm, column inner diameter: 4.6 mm), manufactured by Tosoh Corporation

### (Measurement Conditions)

Solvent: tetrahydrofuran (THF)
Measurement temperature: 40°C
Flow rate: 0.35 mL/min
Sample concentration: 10 mg/5 mL of THF
Injection volume: 20 µL

### [Production of Photosensitive Resin Composition and Photosensitive Resin Film]

### Examples 1 to 8 and Comparative Examples 1 to 5

### (1) Production of Photosensitive Resin Composition

Each component was blended according to the blending composition shown in Table 1 (the unit of the numerical value in the table is a part by mass, and in the case of a solution, it is an amount converted into a solid content) and kneaded using a three roll mill and a self-revolving mixer. Thereafter, methyl ethyl ketone was added so that the solid content concentration became 65% by mass, to obtain a photosensitive resin composition.

### (2) Production of Photosensitive Resin Film

A polyethylene terephthalate film (manufactured by Teijin Limited, trade name "G2-16") having a thickness of 16 µm was used as a carrier film. The photosensitive resin composition prepared in each example was applied to the carrier film so that the film thickness after drying was 25 µm, and dried at 100°C for 10 minutes using a hot air convection type dryer to form a photosensitive resin film. Subsequently, a polyethylene film (manufactured by Tamapoly Co., Ltd., trade name "NF-15") was attached as a protective film to the surface of the photosensitive resin film on the side opposite to the side in contact with the carrier film, thereby preparing a photosensitive resin film to which the carrier film and the protective film were attached.

### [Measurement of Relative Dielectric Constant (Dk) and Dielectric Dissipation Factor (Df)]

Two photosensitive resin films from which the protective film had been peeled off were attached and irradiated with 400 mJ/cm² (wavelength of 365 nm) by a plane exposure machine and 2 J/cm² (wavelength of 365 nm) by a UV conveyor type exposure machine while holding the carrier films on both surfaces. Then, the film was heat-treated at 170°C for 1 hour using a hot air circulation type dryer, and cut into a size of 7 cm × 10 cm to obtain an evaluation sample. The obtained evaluation sample was dried for 10 hours or more after sealing a desiccant therein, and the relative dielectric constant (Dk) and the dielectric dissipation factor (Df) in the 10 GHz band were measured by the split post dielectric resonator method (SPDR method).

### [Measurement of Minimum Development Time]

A copper foil surface of a substrate for a printed wiring board (manufactured by Resonac Corporation, trade name "MCL-E-679") obtained by laminating a copper foil (thickness: 12 µm) on a glass epoxy substrate was subjected to a pre-roughening treatment with a pre-roughening treatment solution (manufactured by MEC Company Ltd., trade name "CZ-8101"), and then washed with water and dried. Next, the photosensitive resin film from which the protective film was peeled was laminated on the copper foil of the substrate for a printed wiring board subjected to the pre-roughening treatment so that the photosensitive resin film was an attachment surface. For the laminating, a press-type vacuum laminator (manufactured by The Japan Steel Works, Ltd., Meiki Plant, trade name "MVLP-500") was used, and the laminating conditions were a press hot plate temperature of 75°C, a vacuuming time of 20 seconds, a laminating press time of 30 seconds, a pressure of 4 kPa or less, and a compression pressure of 0.4 MPa. After the lamination treatment, the laminate was allowed to stand at room temperature for 1 hour or more to obtain a laminated body for evaluation in which the photosensitive resin film and the carrier film were laminated in this order on the copper foil surface of the substrate for a printed wiring board.

The carrier film of the laminated body for evaluation obtained above was removed, and the photosensitive resin film was spray-developed using a 1% by mass sodium carbonate aqueous solution at 30°C. At this time, the minimum time for which development could be performed was defined as the minimum development time.

### [Measurement of Adhesive Strength with Copper Plating]

### (1) Preparation of Laminated Body for Evaluation and Sensitivity Measurement of Photosensitive Resin Film

A laminated body for evaluation was prepared by the same procedure as in the above "Measurement of Minimum Development Time", and a 41-step tablet was placed on the carrier film of the laminated body for evaluation. Next, exposure was performed using a parallel light exposure machine (manufactured by ORC Manufacturing Co., Ltd., trade name "EXM-1201") using an ultrahigh pressure mercury lamp as a light source.

After the exposure, the laminated body for evaluation was allowed to stand at room temperature for 30 minutes, the carrier film of the laminated body for evaluation obtained above was removed, and the photosensitive resin film was subjected to spray development with a 1% by mass sodium carbonate aqueous solution at 30°C. The amount of exposure energy at which the gloss remaining step number was 8.0 was determined, and this was defined as the sensitivity (unit: mJ/cm²) of the photosensitive resin film.

### (2) Exposure Step and Development Step

The laminated body for evaluation was subjected to whole surface exposure with the amount of exposure energy as the sensitivity obtained above to cure the photosensitive resin film. After the exposure, the laminated body for evaluation was allowed to stand at room temperature for 30 minutes, the carrier film of the laminated body for evaluation was peeled and removed, and the photosensitive resin film was subjected to spray development with a 1% by mass sodium carbonate aqueous solution at 30°C for a development time twice the minimum development time.

### (3) Post-Cure Treatment

Subsequently, post-UV curing was performed at a conveyor speed at which the exposure amount was 2 J/cm² using a UV conveyor apparatus of a high-pressure mercury lamp irradiation type (manufactured by ORC Manufacturing Co., Ltd.). Thereafter, the photosensitive resin film was heated at 170°C for 1 hour using a hot air circulation type dryer to obtain a laminated body for evaluation having an interlayer insulating layer formed by curing the photosensitive resin film.

### (4) Roughening Treatment

The heated laminated body for evaluation was treated at 70°C for 5 minutes using a swelling solution "Swelling Dip SECURIGANTH P", and then subjected to a roughening treatment at 70°C for 10 minutes using a roughening solution "Dosing SECURIGANTH P-500J". Subsequently, a neutralization treatment was performed at 50°C for 5 minutes using a neutralizing solution "Reduction Conditioner SECURIGANTH P500". Thereafter, a hydrofluoric acid treatment was performed at room temperature for 10 minutes using buffered hydrofluoric acid "LAL1800 SA Ultra High Purity Buffered Hydrogen Fluoride". Note that the swelling solution, the roughening solution, and the neutralizing solution were all manufactured by Atotech Japan K.K., and the buffered hydrofluoric acid was manufactured by Stella Chemifa Corporation.

### (5) Plating Treatment

The laminated body for evaluation after the roughening treatment was subjected to an electroless plating treatment at 30°C for 15 minutes using an electroless plating solution "Print Gantt MSK-DK" (manufactured by Atotech Japan K.K.). Next, an electroplating treatment was performed at 24°C and 2 A/dm² for 1.5 hours using an electroplating solution "Cupracid HL" (manufactured by Atotech Japan K.K.) to form plated copper on the interlayer insulating layer. The thickness of the plated copper was set to 25 µm.

### (6) Measurement of Adhesive Strength with Plated Copper

The adhesive strength with the plated copper was measured by measuring the vertical peel strength at 23°C in accordance with JIS C 6481:1996 and using the measured value as the adhesive strength with copper plating.

Note that "floating" in the table means peeling between copper plating and an interlayer insulating layer or peeling between an interlayer insulating layer and a copper substrate interface.

### [Measurement of Desmear Weight Reduction Amount]

A laminated body for evaluation having an interlayer insulating layer was prepared in the same procedure as in the above-described "[Measurement of Adhesive Strength with Copper Plating]", and the laminated body for evaluation was immersed in a swelling solution "Swelling Dip SECURIGANTH P" (glycol ethers, an aqueous solution of sodium hydroxide, manufactured by Atotech Japan K.K.) at 70°C for 10 minutes and then washed with water at 25°C for 3 minutes. Next, the laminated body was immersed in a roughening solution "Concentrate Compact P" (an aqueous solution of KMnO₄: 60 g/L and NaOH: 40 g/L, manufactured by Atotech Japan K.K.) at 80°C for 15 minutes, and then washed with water at 50°C for 1 minute. Finally, the laminated body was immersed in a neutralizing solution "Reduction Solution SECURIGANTH P" (an aqueous solution of sulfuric acid, manufactured by Atotech Japan K. K.) at 40°C for 5 minutes, and then washed with water at 25°C for 3 minutes. Thereafter, the laminated body was dried at 105°C for 10 minutes to obtain a laminated body for evaluation after the desmear treatment. The difference between the weight of the laminated body for evaluation before the desmear treatment and the weight of the laminated body for evaluation after the desmear treatment [before desmear treatment - after desmear treatment] was taken as the desmear weight reduction amount.

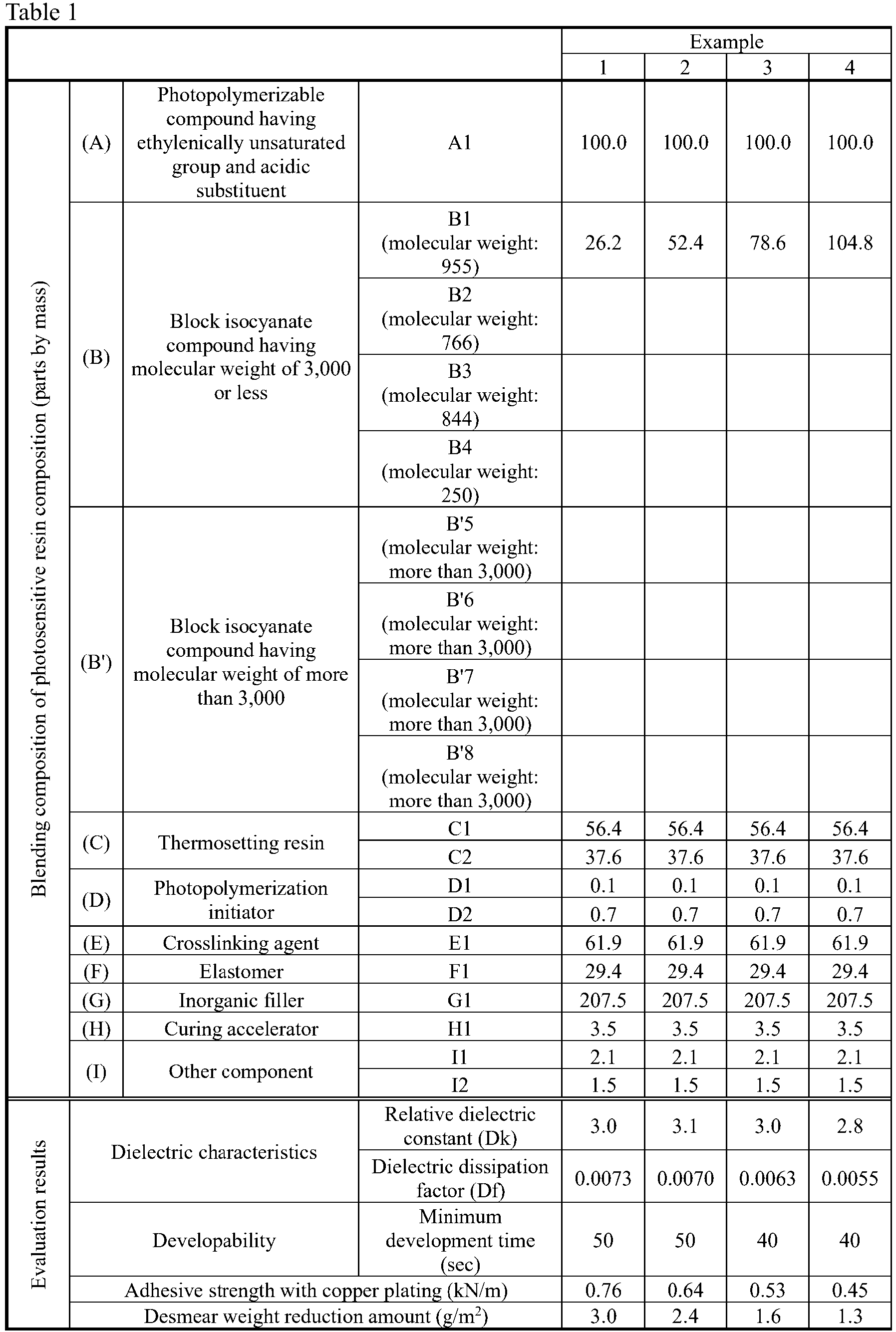

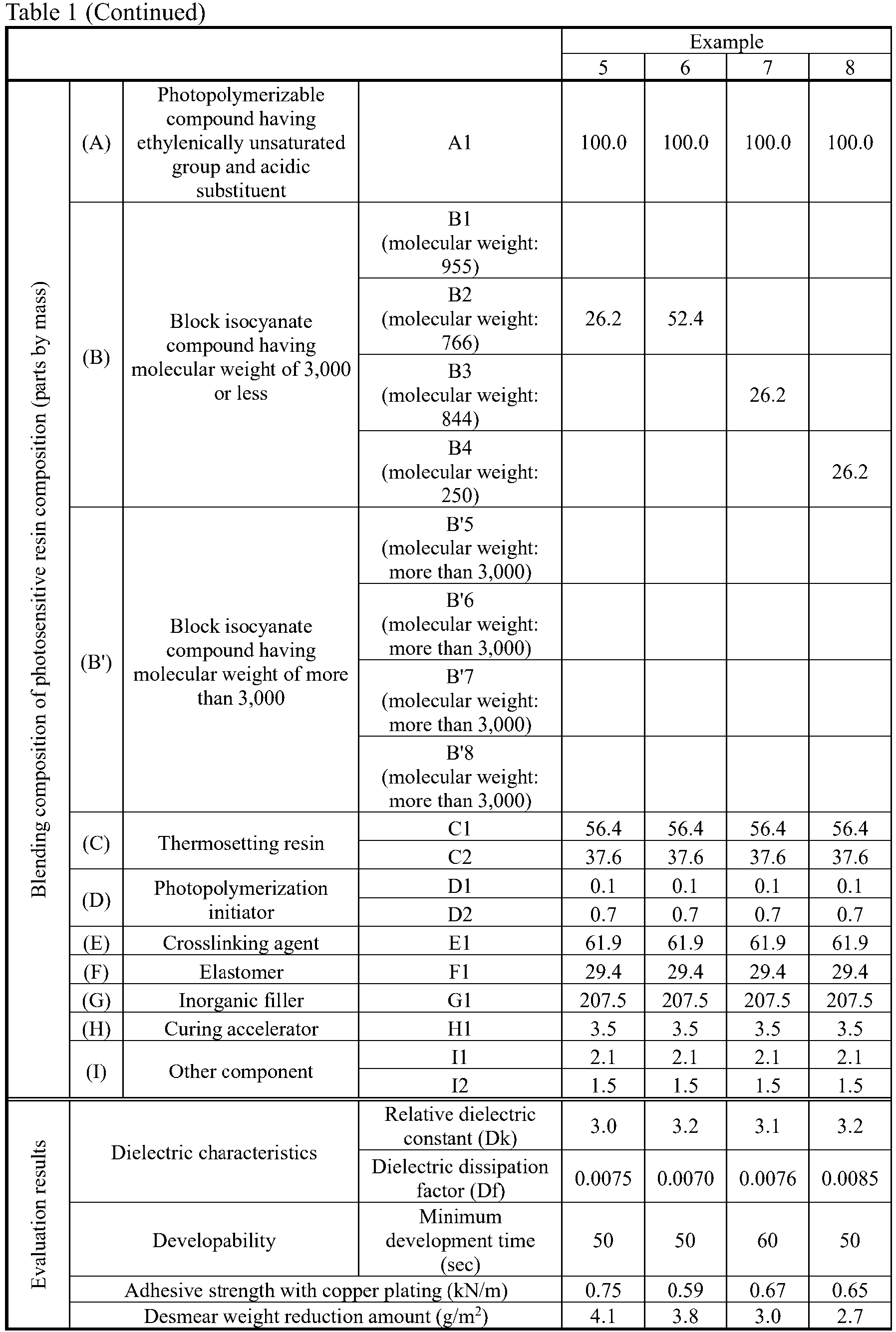

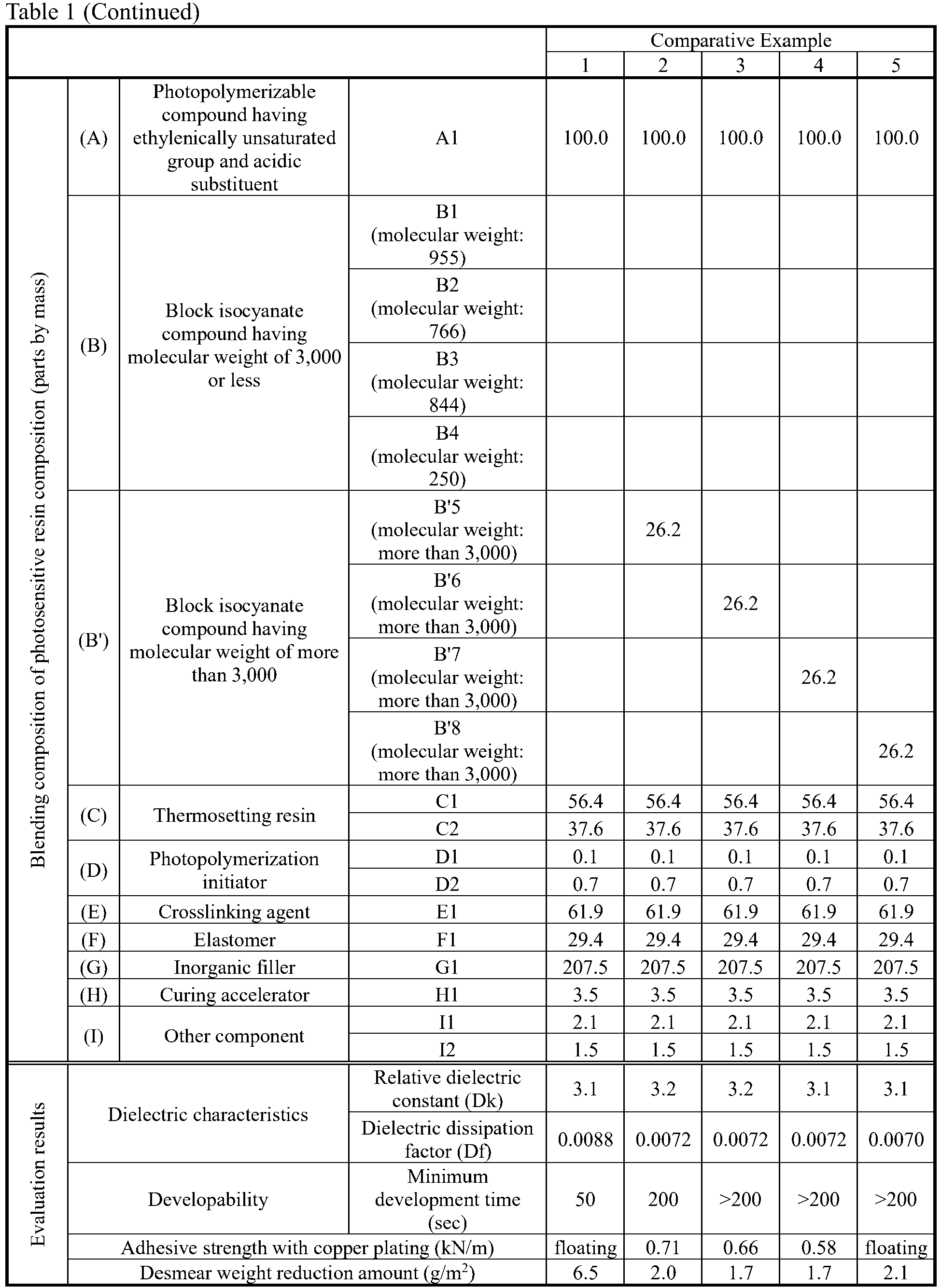

The components used in Table 1 are as follows.

### [(A) Photopolymerizable compound having ethylenically unsaturated group and acidic substituent]

- A1: "ZXR-1935H" (manufactured by Nippon Kayaku Co., Ltd., acid value: 110 mgKOH/g, weight-average molecular weight (Mw): 2,000), a photopolymerizable compound having an ethylenically unsaturated group and an acidic substituent and containing an alicyclic skeleton represented by the above general formula (A-1)

### [(B) Block isocyanate compound having molecular weight of 3,000 or less]

- B1: "BI7951" (manufactured by LANXESS), molecular weight: 955, dissociation temperature: 120°C, a block isocyanate compound obtained by blocking an isocyanate group of a trimer of isophorone diisocyanate represented by the following formula with 3,5-dimethylpyrazole (DMP) 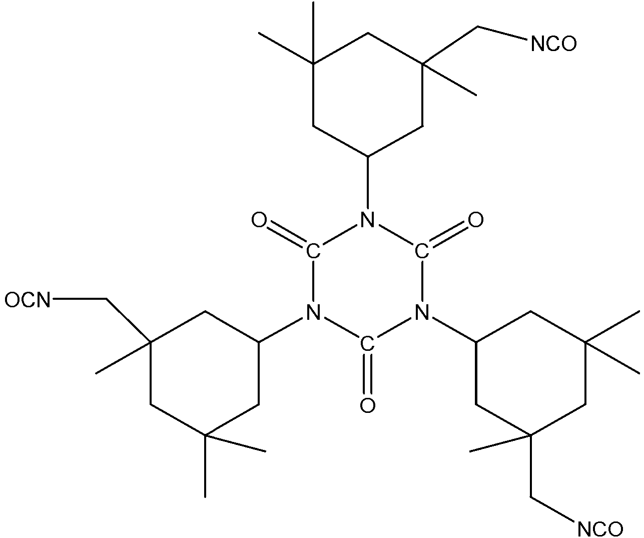
- B2: "TPA-B80E" (manufactured by Asahi Kasei Corporation), molecular weight: 766, dissociation temperature: 130°C, a block isocyanate compound obtained by blocking an isocyanate group of a trimer of 1,6-hexamethylene diisocyanate represented by the following formula with 2-butanoneoxime 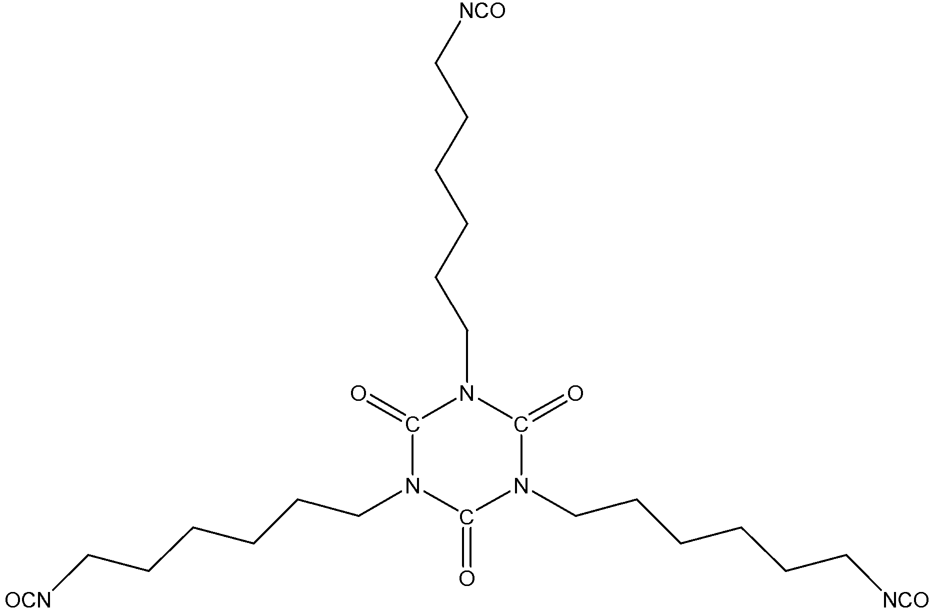
- B3: "Coronate 2554" (manufactured by Tosoh Corporation), molecular weight: 844, dissociation temperature: 160°C, a block isocyanate compound obtained by blocking an isocyanate group of a trimer of 1,6-hexamethylene diisocyanate represented by the following formula with ε-caprolactam 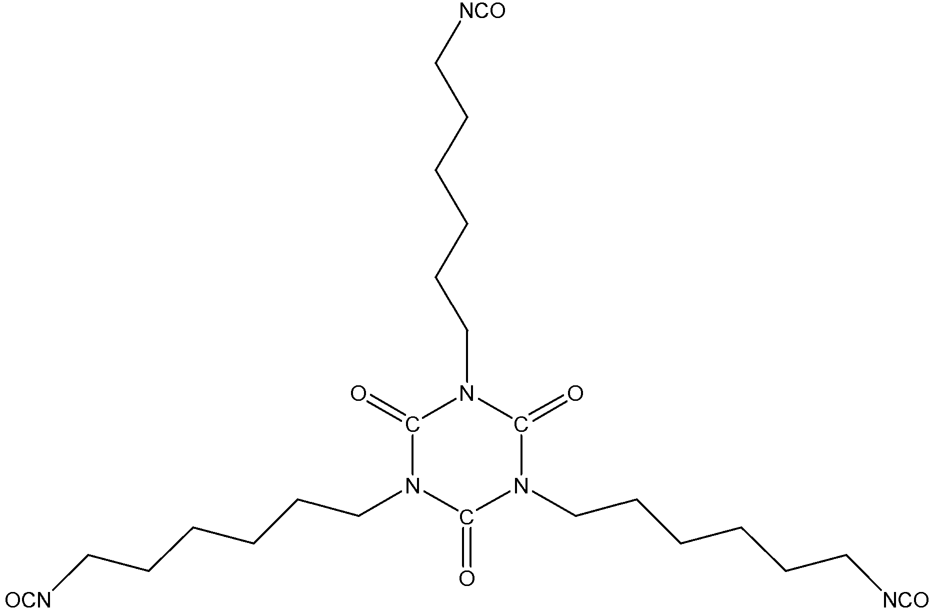
- B4: "MOI-MP" (manufactured by Resonac Corporation), molecular weight: 250, dissociation temperature: 170°C, a block isocyanate compound obtained by blocking 2-isocyanatoethyl methacrylate with 1-methoxy-2-propanol

### [(B') Block isocyanate compound having molecular weight of more than 3,000]

- B'5: "Blonate 1950" (manufactured by Daiei Sangyo Kaisha, Ltd.), molecular weight: more than 3,000, dissociation temperature: 140°C, phenol-blocked polyisocyanate
- B'6: "Blonate 1901" (manufactured by Daiei Sangyo Kaisha, Ltd.), molecular weight: more than 3,000, dissociation temperature: 140°C, phenol-blocked polyisocyanate
- B'7: "Blonate 1631V01" (manufactured by Daiei Sangyo Kaisha, Ltd.), molecular weight: more than 3,000, dissociation temperature: 150°C, oxime-blocked polyisocyanate
- B'8: "Blonate 1227EV" (manufactured by Daiei Sangyo Kaisha, Ltd.), molecular weight: more than 3,000, dissociation temperature: 80 to 100°C, active methylene-based polyisocyanate

### [(C) Thermosetting resin]

- C1: "Epotohto (registered trademark) ESN-475V" (manufactured by NIPPON STEEL Chemical & Material Co., Ltd.), α-naphthol aralkyl type epoxy resin, acid value: 110 mgKOH/g, weight-average molecular weight (Mw): 2,000
- C2: "NC-3000L" (manufactured by Nippon Kayaku Co., Ltd.), biphenyl aralkyl type epoxy resin, epoxy equivalent: 272 g/eq.

### [(D) Photopolymerization initiator]

- D1: "Irgacure OXE02" (manufactured by BASF Japan Ltd.), oxime ester-based compound
- D2: "Omnirad 819" (manufactured by IGM Resins B.V.) acylphosphine oxide-based compound

### [(E) Crosslinking agent]

- E1: "DPHA" (dipentaerythritol hexaacrylate)

### [(F) Elastomer]

- F1: "Ricon (registered trademark) 131MA17" (manufactured by Cray Valley), maleic acid-modified polybutadiene, number-average molecular weight (Mn): 54,000 (catalog value)

### [(G) Inorganic filler]

- G1: Spherical fused silica (volume-average particle diameter (D₅₀): 0.5 µm)

### [(H) Curing accelerator]

- H1: 1-benzyl-2-phenylimidazole

### [(I) Other Component]

- I1: 4,4'-bis-(diethylamino)benzophenone (sensitizer)
- I2: t-butyl catechol (polymerization inhibitor)

As can be seen from Table 1, all of the photosensitive resin compositions of Examples 1 to 8 of the present embodiment had both good dielectric characteristics and developability. On the other hand, the photosensitive resin compositions of Comparative Examples 1 to 5 which did not satisfy the constitution of the photosensitive resin composition of the present embodiment were inferior in either dielectric characteristics or developability.

### Reference Signs List

100A: Multilayered printed wiring board
101: Substrate
102: Circuit pattern
103: Photosensitive layer
104: Interlayer insulating layer
105: Via
106: Seed layer
107: Resist pattern
108: Copper circuit layer
109: Solder resist layer

## Claims

1. A photosensitive resin composition comprising:
(A) a photopolymerizable compound having an ethylenically unsaturated group and an acidic substituent; and
(B) a block isocyanate compound having a molecular weight of 3,000 or less.

2. The photosensitive resin composition according to claim 1, wherein the component (B) has a dissociation temperature of 80 to 250°C.

3. The photosensitive resin composition according to claim 1 or 2, wherein the component (B) is a compound containing an isocyanurate ring.

4. The photosensitive resin composition according to claim 3, wherein the component (B) is a compound obtained by blocking a trifunctional isocyanate compound containing an isocyanurate ring with a blocking agent.

5. The photosensitive resin composition according to claim 1 or 2, wherein a content of the component (B) is 1 to 40% by mass based on the total amount of the resin components.

6. The photosensitive resin composition according to claim 1 or 2, wherein the component (A) contains an alicyclic skeleton represented by the following general formula (A-1): 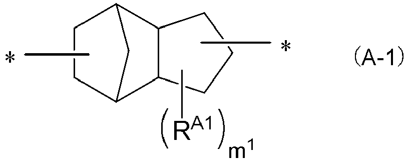 wherein R^{A1} represents an alkyl group having 1 to 12 carbon atoms, and may be substituted at any position in the alicyclic skeleton; m¹ is an integer of 0 to 6; and * is a bonding site to another structure.

7. The photosensitive resin composition according to claim 1 or 2, further comprising (C) a thermosetting resin.

8. The photosensitive resin composition according to claim 1 or 2, further comprising (D) a photopolymerization initiator.

9. The photosensitive resin composition according to claim 1 or 2, further comprising (E) a crosslinking agent.

10. The photosensitive resin composition according to claim 1 or 2, further comprising (F) an elastomer.

11. The photosensitive resin composition according to claim 1 or 2, further comprising (G) an inorganic filler.

12. The photosensitive resin composition according to claim 1 or 2, which is used for forming a photovia.

13. A photosensitive resin film comprising the photosensitive resin composition according to claim 1 or 2.

14. A printed wiring board comprising a cured product of the photosensitive resin composition according to claim 1 or 2.

15. A semiconductor package comprising the printed wiring board according to claim 14; and a semiconductor element.
